# EUROPEAN PATENT APPLICATION

(11) **EP 4 679 716 A1**
(43) Date of publication of application: **14.01.2026**
(21) Application number: 24188323.0
(22) Date of filing: 12.07.2024
(51) Int. Cl.: H03K 17/693, H01P 1/15, H03H 7/40, H03K 17/74

(54) **SWITCHING CIRCUIT, AND IMPEDANCE TUNING NETWORK**

(71) Applicant: Rohde & Schwarz GmbH & Co. KG, 81671 München (DE)
(72) Inventor: Fruehauf, Adrian, 81671 München (DE); Czobor, Gabor, 81671 München (DE)
(74) Representative: Prinz & Partner mbB

(57) **Abstract**

A switching circuit (10) for selectively closing or interrupting a radio frequency, RF, signal path (12) is described. The switching circuit (10) comprises a switchable element (20), wherein the switchable element (20) is switchable between an on-state and an off-state. The switching circuit (10) further comprises a control circuit (22) and a power supply module (24). The control circuit (22) is configured to apply a control signal provided by the power supply module (24) to the switchable element (20), wherein the control signal comprises a control voltage and/or a control current. The control circuit (22) comprises a first signal path (28), wherein the first signal path (28) comprises at least one first diode (32) being configured to provide the control signal to the switchable element (20). The control circuit (22) comprises a second signal path (30), wherein the second signal path (30) is arranged in parallel to the first signal path (28). The second signal path (30) comprises at least one second diode (40), wherein the at least one second diode (40) is arranged with opposite polarity compared to the at least one first diode (32). Further, an impedance tuning network is described.

## Description

The present invention generally relates to a switching circuit for selectively closing or interrupting an radio frequency, RF, signal path. The present invention further relates to an impedance tuning network.

Certain RF applications require electronic switches that are capable of rapidly switching between an on-state and an off-state.

Such an electronic switch usually requires a DC control signal delivered via a DC control signal path to engage the switching operation.

This DC control signal or rather the DC control signal path needs to be isolated from the RF signal to prevent damage and/or unwanted interference. Accordingly, RF suppressing elements or components that perform this isolation or separation between DC and RF are required.

Especially if the concerned RF voltages are high, such as several hundred volt, such RF suppressing elements become comparably large in size.

Furthermore, these RF suppressing elements usually act as an energy storage, which ultimately reduces the switching speed of the switching circuit. Moreover, the RF suppressing elements may be resistive and thus be associated with additional losses.

Thus, the object of the present invention is to provide a switching circuit for selectively closing or interrupting an RF signal path that provides an enhanced switching speed and/or reduced spatial requirements.

According to the present invention, the problem is solved by a switching circuit for selectively closing or interrupting a radio frequency, RF, signal path. The switching circuit comprises a switchable element, wherein the switchable element is switchable between an on-state and an off-state. The switching circuit further comprises a control circuit and a power supply module. The control circuit is configured to apply a control signal provided by the power supply module to the switchable element, wherein the control signal comprises a control voltage and/or a control current. The control circuit comprises a first signal path, wherein the first signal path comprises at least one first diode being configured to provide the control signal to the switchable element. The control circuit comprises a second signal path, wherein the second signal path is arranged in parallel to the first signal path. The second signal path comprises at least one second diode, wherein the at least one second diode is arranged with opposite polarity compared to the at least one first diode.

Therein and in the following, the terms "module", "circuit", and "element" are understood to describe suitable hardware, or a combination of hardware and software that is configured to have a certain functionality.

The hardware may, inter alia, comprise a CPU, a GPU, an FPGA, an ASIC, diodes, field effect transistors (FETs), inductors, capacitors, resistors, or other types of electronic circuitry.

The switching circuit according to the present disclosure is based on the idea to provide at least one pair of diodes in the two parallel signal paths, wherein the diodes are arranged with opposite polarity.

As will be described in more detail below, the diodes may be connected to independent control signal sources or rather bias voltages.

One of the diodes, namely the first diode, provides the control signal to the switchable element, wherein the control signal causes the switchable element to close the RF signal path, keep the RF signal path closed, interrupt the RF signal path, or keep the RF signal path interrupted.

In other words, the control signal provided to the switchable element via the at least one first diode may cause the switchable element to switch from the off-state to the on-state, remain in the on-state, switch from the on-state to the off-state, or remain in the off-state.

The at least one second diode, which has opposite polarity compared to the at least one first diode, accelerates the switching at least from the on-state to the off-state, as the at least one second diode enables charge stored in the switchable element to be transported away from the switchable element quickly.

Further, using a diode, namely the first diode, to provide the control signal to the switching element allows to reduce the impedance of RF suppressing components in the control circuit, or to even omit these RF suppressing components completely.

As a result, less magnetic and/or electric energy is stored in these protective components during switching from the on-state to the off-state or vice versa, which further enhances the attainable switching speed.

Further, this allows to omit RF suppressing components that are physically large, i.e. that require a large volume, thereby reducing the spatial requirements of the switching circuit.

It has turned out that switching times attainable with the switching circuit according to the present invention may be substantially smaller than for electronic switches known in the state of the art.

In fact, switching times of the order of microseconds, or even below one microsecond are attainable.

Moreover, as diodes have a rather small residual capacity, the switching circuit according to the present invention provides a reduced detuning of an impedance of the RF signal path, particularly in the off-state of the switchable element.

The switching circuit according to the present disclosure may be configured for high voltages, i.e. voltages between approximately 100 V and 10 kV.

The switchable element may be interconnected between an RF signal source and a reference potential, i.e. in the on-state of the switchable element the RF current flows to or from the reference potential.

According to an aspect of the present invention, the control circuit further comprises at least one RF suppressing element, wherein the at least one RF suppressing element is arranged in the first signal path, in the second signal path, and/or in series with the first signal path and the second signal path. In general, the at least one RF suppressing element is configured to dampen or completely block RF currents through the at least one first diode.

In fact, in the on-state of the switching element, the proportion of the RF current flowing through the switchable element compared to the proportion of the RF current flowing through the at least one first diode can be set through the impedance of the RF suppressing element.

For example, the impedance, particularly the inductance and/or resistance of the at least one RF suppressing element may be chosen such that a predefined percentage of the RF current flows through the switchable element, e.g. more than 50% or more than 75%.

Therein, it is to be understood that the impedance particularly the inductance of the RF suppressing element can be chosen to be smaller than in the prior art, or the RF suppressing element can even be omitted. Thus, faster switching speeds are provided.

For example, the at least one RF suppressing element may be or comprise at least one resistor and/or at least one inductor.

As another example, the at least one RF suppressing element may be or comprise an LC parallel circuit, i.e. a parallel circuit having at least one inductor and at least one capacitor.

However, it is to be understood that the at least one RF suppressing element may be or comprise any other suitable type of electronic circuitry being configured to dampen or block RF currents.

For example, the at least one RF suppressing element may be purely resistive.

In an embodiment of the present invention, the at least one RF suppressing element is arranged in the first signal path, wherein the at least one RF suppressing element is arranged in series with the at least one first diode. The advantages and properties of the at least one RF suppressing element described above likewise apply.

In a further embodiment of the present invention, the first signal path and the second signal path each are to connected to a common connection point, wherein the switchable element is connected to the common connection point. Accordingly, the control signal is provided to the switchable element via the first signal path and the common connection point. When switching from the on-state to the off-state, the switchable element may be discharged via the common connection point and the second signal path.

According to another aspect of the present invention, the switchable element is a diode. As diodes usually have a rather small residual capacity, influences of the switching circuit on an impedance of the RF signal path or of a circuit connected to the RF signal path are reduced, namely in the off-state of the switching element.

However, it is to be understood that the switchable element may also be established as a field effect transistor (FET) or as another suitable type of electronic circuitry.

Particularly, the switchable element is or comprises a PIN diode, a PN-Si diode, or a PN-SiC diode.

PIN diodes have a particularly small residual capacity, such that influences of the switching circuit on an impedance of the RF signal path or of a circuit connected to the RF signal path are minimized.

Using SiC diode(s), the switching speed can be further enhanced and the manufacturing costs of the switching circuit can be reduced.

In an embodiment of the present invention, the at least one first diode is a PIN diode, a PN-Si diode, or a PN-SiC diode, and/or wherein the at least one second diode is a PIN diode, a PN-Si diode, or a PN-SiC diode.

As explained above, PIN diodes have a particularly small residual capacity, such that influences of the switching circuit on an impedance of the RF signal path or of a circuit connected to the RF signal path are minimized.

Using PN-Si diode(s) or PN-SiC diode(s), the switching speed can be further enhanced and the manufacturing costs of the switching circuit can be reduced.

The first signal path may comprise a plurality of first diodes. More precisely, the plurality of first diodes may be arranged in a series connection. This allows to employ a plurality of diodes that are, individually, more cost efficient, as the individual diodes do not have to meet the requirements of the switching circuit e.g. regarding a blocking voltage. Instead, it is sufficient that series connection of the plurality of first diodes meets these requirements. In fact, it has turned out that employing a plurality of first diodes meeting these requirements together may be more cost-efficient than employing a single diode meeting the requirements.

For example, if the first signal path comprises a plurality of diodes, the individual diodes may be established as Si-diodes instead of PIN diodes or SiC diodes, wherein the Si-diodes are obtainable at reduced cost, thereby reducing the manufacturing costs for the switching circuit.

Alternatively or additionally, the second signal path may comprise a plurality of second diodes. More precisely, the plurality of diodes may be arranged in a series connection. This allows to employ a plurality of diodes that are, individually, more cost efficient, as the individual diodes do not have to meet the requirements of the switching circuit e.g. regarding a blocking voltage. Instead, it is sufficient that series connection of the plurality of second diodes meets these requirements. In fact, it has turned out that employing a plurality of second diodes meeting the requirements together may be more cost-efficient than employing a single diode meeting the requirements.

For example, if the second signal path comprises a plurality of diodes, the individual diodes may be established as Si-diodes instead of PIN diodes or SiC diodes, wherein the Si-diodes are obtainable at reduced cost, thereby reducing the manufacturing costs for the switching circuit.

An aspect of the present invention provides that the power supply module comprises a first bias supply and a second bias supply, wherein the first bias supply is connected to the first signal path, and wherein the second bias supply is connected to the second signal path. This enables to provide different bias voltages to the at least one first diode and to the at least one second diode.

In other words, the first bias supply may be independent of the second bias supply.

Particularly, the first bias supply comprises a first half bridge. Alternatively or additionally, the second bias supply may comprise a second half bridge. Therein, the first half bridge and the second half bridge may be connected to different voltage sources being independent of each other. This way, different voltage levels for the first signal path and for the second signal path can be generated, particularly wherein the different voltage levels may be generated with different timings.

In fact, the second half bridge may provide an intermediate voltage level for switching the switchable element from the on-state to the off-state. This allows for a particularly fast switching between the on-state and the off-state.

In a static off-state of the switchable element, the second half bridge may provide a reverse bias voltage for the first diode, the second diode, and the switchable element. This further reduces the residual capacitance of the switching circuit, particularly the residual capacitances of the first diode, the second diode, and/or the switchable element.

The half bridges may each comprise or consist of a plurality of switches.

A switch may comprise at least one transistor or a plurality of transistors, e.g. a bipolar transistor, an Insulated-Gate Bipolar Transistor (IGBT), an FET, a MOSFET (e.g. Si, SiC, GaN), or any other suitable type of transistor.

Alternatively or additionally, the half bridges each may comprise resistive and/or reactive components.

According to the present invention, the problem further is solved by an impedance tuning network. The impedance tuning network comprises at least one switching circuit according to any one of the variants described above.

Regarding the advantages and further properties of the impedance tuning network, reference is made to the explanations given above with respect to the switching circuit, which also hold for the impedance tuning network and vice versa.

Therein and in the following, the term "impedance tuning" is understood to denote altering the impedance of a certain circuit at a fixed or variable frequency and/or shifting an impedance characteristic of the circuit to another frequency.

According to an aspect of the present invention, the impedance tuning network comprises at least one impedance tuning module, wherein the impedance tuning module comprises at least one reactance and the at least one switching circuit, and wherein the at least one switching circuit is configured to selectively connect the at least one reactance to or into an RF signal path of the impedance tuning network. In other words, the at least one reactance can be connected to and/or into the RF signal path of the impedance tuning network by the at least one switching circuit, namely by switching the switchable element to its on-state. The at least one reactance can be disconnected from the RF signal path, namely by switching the switchable element to its off-state.

The RF signal path ("RF bus") may be a transmission line.

The at least one reactance may be or comprise at least one capacitance and/or at least one inductance.

According to another aspect of the present invention, the impedance tuning network is established as an impedance matching network, particularly for plasma processes or for an RF antenna. In fact, an impedance of the impedance matching network can be adapted by selectively connecting the at least one reactance to or into an RF signal path of the impedance matching network.

The RF antenna may be associated with an MRI application or with a communication device.

For plasma processes, the impedance matching network may be provided between an RF signal generator generating an RF signal for exciting plasma, i.e. for biasing, sourcing and/or striking the plasma, and a plasma process chamber. An impedance presented to the RF signal generator generating the RF signal can be adapted, namely adapted based on the impedance of the plasma varying over time.

For RF antennas, desired transmission and/or reception properties can be obtained by tuning the impedance of the impedance matching network connected to the RF antenna(s) appropriately.

According to a further aspect of the present disclosure, the impedance tuning network is configured to tune an impedance characteristic of a tunable filter. In fact, the impedance tuning network may be configured to adapt the impedance characteristic of the tunable filter at a fixed frequency and/or shift the impedance characteristic of the tunable filter to another frequency.

For example, the tunable filter may be a hopping filter employed in frequency hopping techniques.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a first variant of a switching circuit according to the present invention;
- Figure 2 schematically shows a second variant of a switching circuit according to the present invention;
- Figure 3 schematically shows a first variant of an impedance tuning network according to the present disclosure;
- Figure 4 schematically shows a second variant of an impedance tuning network according to the present disclosure; and
- Figure 5 schematically shows a fourth variant of an impedance tuning network according to the present disclosure.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

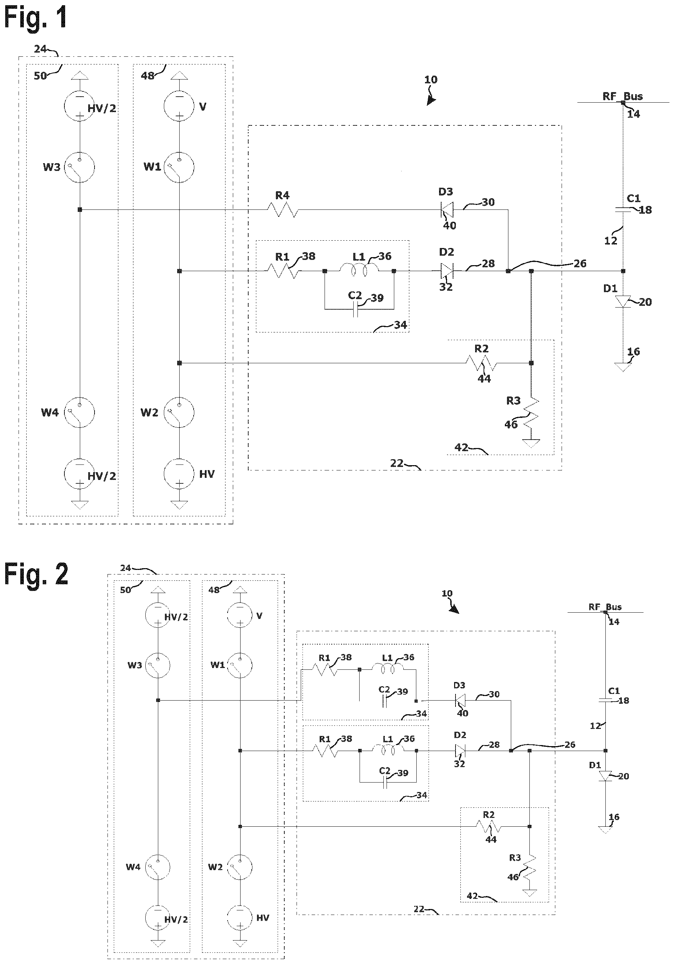

Figure 1 schematically shows a switching circuit 10 being configured to selectively close or interrupt an RF signal path 12.

In the exemplary embodiment shown in Figure 1, the RF signal path 12 extends between an RF signal source 14 and a reference potential 16, wherein a reactance 18 is provided in the RF signal path 12.

For example, the reactance 18 may be a capacitor or an inductor.

However, it is to be understood that other configurations and/or topologies of the RF signal path 12 may be possible.

The switching circuit 10 comprises a switchable element 20 that is provided in the RF signal path 12.

In general, the switchable element 20 is switchable between an on-state and an off-state.

In the on-state, the RF signal path 12 is closed, such that an RF current can flow between the RF signal source 14 and the reference potential 16.

In the off-state, the RF signal path 12 is interrupted, such that no RF current can flow between the RF signal source 14 and the reference potential 16.

In the exemplary embodiment shown in Figure 1, the switchable element 20 is established as a diode, more precisely as a PIN diode.

Alternatively, the switchable element 20 may be established as any other suitable type of electronic component, such as a SiC diode, or as a field effect transistor (FET).

In the embodiment shown in Figure 1, an anode of the switchable element 20 is connected to the RF signal source 14, while a cathode of the switchable element 20 is connected to the reference potential 16.

However, the polarity of the switchable element 20 may also be reversed.

The switching circuit 10 further comprises a control circuit 22 and a power supply module 24.

The control circuit 22 comprises a common connection point 26 that is connected to the switchable element 20 upstream of the switchable element 20, i.e. at the point between the switchable element 20 and the RF signal source 14.

In other words the common connection point 26 is connected to the anode of the switchable element 20, or to the cathode of the switchable element 20 if the polarity of the switchable element 20 is reversed.

The control circuit 22 further comprises a first signal path 28 and a second signal path 30 that are each connected to the common connection point 26 and that extend parallel to each other.

The first signal path 28 comprises at least one first diode 32 that is arranged with the same polarity as the switchable element 20 with respect to the reference potential 16.

Accordingly, a control signal provided by the power supply module 24 can be forwarded to the switchable element 20 via the first diode 32.

Therein, the control signal may be a control current and/or a control voltage.

The at least one first diode 32 may, for example, be a PIN diode, a PN-Si diode, or a PN-SiC diode.

It is noted that the at least one first diode 32 may comprise a plurality of first diodes 32 that are arranged in a series connection. In this case, the plurality of first diodes 32 may be a PIN diode, a SiC diode, or a Si diode, respectively.

The first signal path 28 may further comprise an RF suppressing element 34 that is arranged in a series connection with the at least one first diode 32.

In general the RF suppressing element 34 is configured to dampen or completely block RF signals.

In the exemplary embodiment of Figure 1, the RF suppressing element 34 comprises an inductor 36, a resistor 38, and a capacitor 39.

However, it is to be understood that any other suitable type of electronic circuitry may be used, for example only a resistor, only an inductor, only an LC parallel circuit, or any combination of these components.

Alternatively to the topology shown in Figure 1, the RF suppressing element 34 may be arranged in series to the first signal path 28 and the second signal path 30, for example between the common connection point 26 and the RF signal path 12.

The second signal path 30 comprises at least one second diode 40 that is arranged with opposite polarity compared to the switchable element 20 with respect to the reference potential 16.

Accordingly, the at least one first diode 32 and the at least one second diode 40 are arranged with opposite polarities.

When switching the switchable element 20 from the on-state to the off-state, the at least one second diode 40 enables of the connection of a reverse voltage pulse and/or current pulse to the switchable element 20, such that the switching speed is increased.

The at least one second diode 40 may, for example, be a PIN diode, a PN-Si diode, or a PN-SiC diode.

It is noted that the at least one second diode 40 may comprise a plurality of second diodes 40 that are arranged in a series connection. In this case, the plurality of second diodes 40 may be a PIN diode, a SiC diode, or a Si diode, respectively.

The control circuit 22 may further comprise a voltage divider 42 being connected to the common connection point 26, the reference potential 16, and the power supply module 24.

More precisely, the voltage divider 42 is a resistive voltage divider comprising a first resistor 44 and a second resistor 46, wherein the second resistor 46 is optional.

The first resistor 44 is connected between the common connection point 26 and the power supply module 24, while the second resistor 46 is connected between the common connection point 26 and the reference potential 16.

In the off-state of the switchable element 20, the voltage divider 42 ensures a controlled distribution of a blocking voltage to the switchable element 20 and to the at least one first diode 32.

It is noted that the switching circuit 10 described above and hereinafter may alternatively be implemented with all of the polarities of the switchable element 20, the at least one first diode 32, and the at least one second diode 40 reversed.

The power supply module 24 comprises a first bias supply 48 that is connected to the first signal path 28.

The power supply module 24 further comprises a second bias supply 50 that is connected to the second signal path 30.

Therein, the first bias supply 48 and the second bias supply 50 are independent of each other.

In fact, the first bias supply 48 comprises a first half-bridge that allows to set a bias voltage for the at least one first diode 32 and the switchable element 20.

The second bias supply 50 comprises a second half-bridge that allows to set a bias voltage for the at least one second diode 40.

As the first bias supply 48 and the second bias supply 50 are independent of each other and provided separately, different voltage levels with different timings can be provided to the at least one first diode 32 and the at least one second diode 40.

The switching circuit 10 described above is operated as follows.

In the on-state of the switchable element 20 or in order to switch the switchable element 20 the on-state, a corresponding DC bias current is applied to the at least one first diode 32 and to the switchable element 20 by the first bias supply 48.

Due to the bias current, the switchable element 20 becomes conducting and the RF signal path 12 is closed.

In the off-state of the switchable element 20 or in order to switch the switchable element 20 to the off-state, a corresponding DC bias voltage with opposite polarity may be applied to the switchable element 20.

Due to the bias voltage having opposite polarity, the switchable element 20 becomes current-blocking, such that the RF signal path 12 is interrupted.

When switching from the on-state to the off-state, the switchable element 20 can be discharged via the at least one second diode 40.

As the control circuit 22 does not comprise any large energy storages, such as inductors having a large inductance or capacitors having a high capacitance, and due to the possibility to provide a reverse bias pulse to the switchable element 20, the switching circuit 10 described above provides particularly fast switching speeds between the on-state and the off-state and vice versa.

Figure 2 shows a further exemplary embodiment of the switching circuit 10, wherein only the differences compared to the embodiment described above with reference to Figure 1 are explained hereinafter.

In this exemplary embodiment, both the first signal path 28 and the second signal path 30 comprise an RF suppressing element 34.

The RF suppressing element 34 of the first signal path 28 is arranged in a series connection with the at least one first diode 32.

The RF suppressing element 34 of the second signal path 30 is arranged in a series connection with the at least one second diode 40.

The switching circuit 10 described above has a plurality of different fields of application, as will be described in more detail hereinafter.

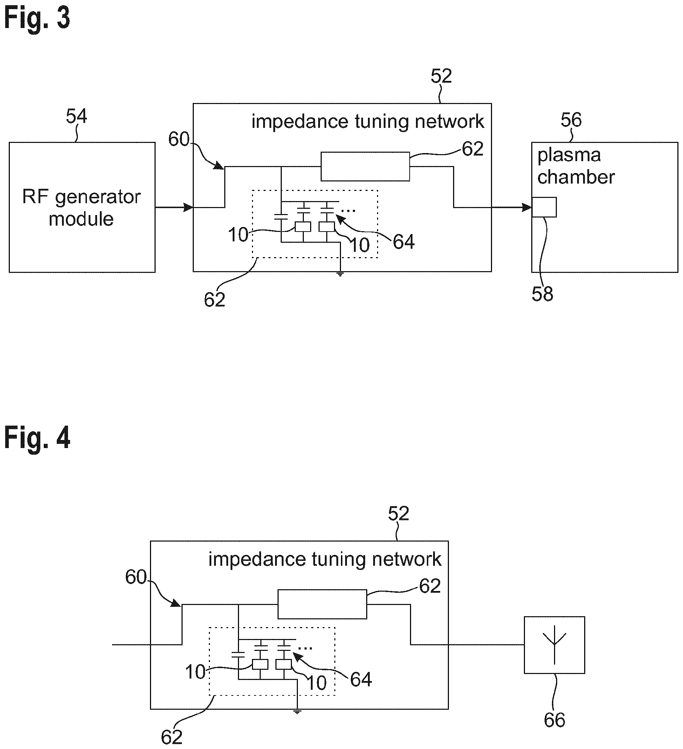

Figure 3 schematically shows an impedance tuning network 52 for plasma applications, wherein the impedance tuning network 52 is established as an impedance matching network.

The impedance tuning network 52 is provided between an RF generator module 54 and a plasma chamber 56 comprising a chamber feed unit 58.

More precisely, the impedance tuning network 52 comprises an RF signal path ("RF bus") 60 that connects the RF generator module 54 to the chamber feed unit 58.

In general, the impedance tuning network 52 is configured to adapt an impedance seen by the RF signal path 60 or connect an impedance into the RF signal path 60, such that a varying impedance of the plasma contained in the plasma chamber 56 is compensated, and such that an optimal load is presented to the RF generator module 54, thereby minimizing losses and maximizing the energy fed into the plasma.

In fact, the impedance tuning network 52 comprises at least one impedance tuning module 62 that is connected to the RF signal path 60.

In general, the at least one impedance tuning module 62 is configured to selectively connect at least one reactance to and/or into the RF signal path 60.

In the exemplary embodiment shown in Figure 3, the at least one impedance tuning module 62 comprises a plurality of capacitors 64 as well as a plurality of switching circuits 10 described above.

In fact, the capacitors 64 can be connected to and/or into the RF signal path 60 individually by the respectively connected switching circuit 10.

More precisely, in the on-state of the respective switchable element 20 of the respective switching circuit 10, the respective capacitor 64 is connected to the RF signal path 60.

In the off-state of the respective switchable element 20 of the respective switching circuit 10, the respective capacitor 64 is disconnected from the RF signal path 60.

By selectively connecting or disconnecting the individual reactances to or from the RF signal path 60, respectively, the impedance of the impedance tuning network 52 can be adapted.

Figure 4 schematically shows an impedance tuning network 52 for an RF antenna 66, wherein the impedance tuning network 52 is established as an impedance matching network for an antenna tuner.

In this case, the impedance tuning network 52 is configured to adapt its impedance in order to set desired transmission and/or reception characteristics of the RF antenna 66, namely by selectively connecting at least one reactance to and/or into the RF signal path 60.

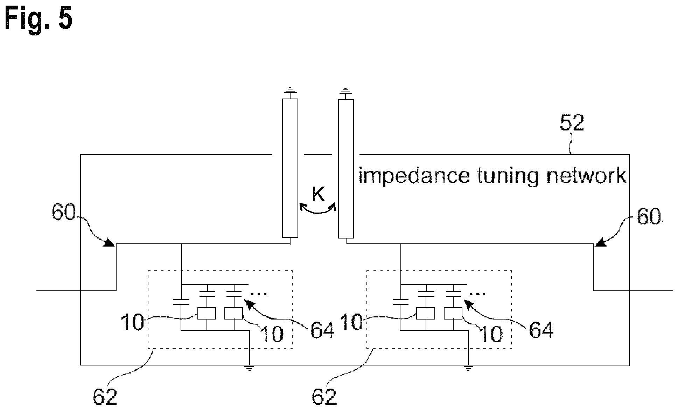

Figure 5 schematically shows an impedance tuning network 52 for a tunable filter, particularly for a hopping filter employed in frequency hopping techniques.

In general, the impedance tuning network 52 is configured to shift the impedance characteristic of the tunable filter to a certain frequency, namely by selectively connecting at least one reactance to and/or into the RF signal path 60.

This way, the tunable filter can be set to have a certain pass-band that can pass the tunable filter.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A switching circuit for selectively closing or interrupting a radio frequency, RF, signal path (12),
wherein the switching circuit (10) comprises a switchable element (20), wherein the switchable element (20) is switchable between an on-state and an off-state,
wherein the switching circuit (10) further comprises a control circuit (22) and a power supply module (24), wherein the control circuit (22) is configured to apply a control signal provided by the power supply module (24) to the switchable element (20), wherein the control signal comprises a control voltage and/or a control current,
wherein the control circuit (22) comprises a first signal path (28), wherein the first signal path (28) comprises at least one first diode (32) being configured to provide the control signal to the switchable element (20), and
wherein the control circuit (22) comprises a second signal path (30), wherein the second signal path (30) is arranged in parallel to the first signal path (28), wherein the second signal path (30) comprises at least one second diode (40), wherein the at least one second diode (40) is arranged with opposite polarity compared to the at least one first diode (32).

2. The switching circuit of claim 1, wherein the control circuit (22) further comprises at least one RF suppressing element (34), wherein the at least one RF suppressing element (34) is arranged in the first signal path (28), in the second signal path (30), and/or in series with the first signal path (28) and the second signal path (30).

3. The switching circuit of claim 2, wherein the at least one RF suppressing element (34) is arranged in the first signal path (28), wherein the at least one RF suppressing element (34) is arranged in series with the at least one first diode (32).

4. The switching circuit according to any one of the preceding claims, wherein the first signal path (28) and the second signal path (30) each are to connected to a common connection point (26), and wherein the switchable element (20) is connected to the common connection point (26).

5. The switching circuit according to any one of the preceding claims, wherein the switchable element (20) is a diode.

6. The switching circuit of claim 5, wherein the switchable element (20) is or comprises a PIN diode, a PN-Si diode, or a PN-SiC diode.

7. The switching circuit according to any one of the preceding claims, wherein the at least one first diode (32) is a PIN diode, a PN-Si diode, or a PN-SiC diode, and/or wherein the at least one second diode (40) is a PIN diode, a PN-Si diode, or a PN-SiC diode.

8. The switching circuit according to any one of the preceding claims, wherein the first signal path (28) comprises a plurality of first diodes (32).

9. The switching circuit according to any one of the preceding claims, wherein the second signal path (30) comprises a plurality of second diodes (40).

10. The switching circuit according to any one of the preceding claims, wherein the power supply module (24) comprises a first bias supply (48) and a second bias supply (50), wherein the first bias supply (48) is connected to the first signal path (28), and wherein the second bias supply (50) is connected to the second signal path (30).

11. The switching circuit of claim 10, wherein the first bias supply (48) comprises a first half bridge, and/or wherein the second bias supply (50) comprises a second half bridge.

12. An impedance tuning network, wherein the impedance tuning network (52) comprises at least one switching circuit (10) according to any one of the preceding claims.

13. The impedance tuning network of claim 12, wherein the impedance tuning network (52) comprises at least one impedance tuning module (62), wherein the impedance tuning module (62) comprises at least one reactance and the at least one switching circuit (10), and wherein the at least one switching circuit (10) is configured to selectively connect the at least one reactance to or into a RF signal path (60) of the impedance tuning network (52).

14. The impedance tuning network of claim 12 or 13, wherein the impedance tuning network (52) is established as an impedance matching network, particularly for plasma processes or for an RF antenna (66).

15. The impedance tuning network of claim 12 or 13, wherein the impedance tuning network (52) is configured to tune an impedance characteristic of a tunable filter.

## Amended claims

### Amended claims in accordance with Rule 137(2) EPC.

1. A switching circuit for selectively closing or interrupting a radio frequency, RF, signal path (12),
wherein the switching circuit (10) comprises a switchable element (20), wherein the switchable element (20) is switchable between an on-state and an off-state,
wherein the switching circuit (10) further comprises a control circuit (22) and a power supply module (24), wherein the control circuit (22) is configured to apply a control signal provided by the power supply module (24) to the switchable element (20), wherein the control signal comprises a control voltage and/or a control current, and
wherein the control circuit (22) comprises a first signal path (28), wherein the first signal path (28) comprises at least one first diode (32) being configured to provide the control signal to the switchable element (20),
**characterized in that** the control circuit (22) comprises a second signal path (30), wherein the second signal path (30) is arranged in parallel to the first signal path (28), wherein the second signal path (30) comprises at least one second diode (40), wherein the at least one second diode (40) is arranged with opposite polarity compared to the at least one first diode (32), such that the switchable element (20) is dischargeable via the at least one second diode (40) when switching from an on-state to an off-state,
wherein the power supply module (24) comprises a first bias supply (48) and a second bias supply (50), wherein the first bias supply (48) is connected to the first signal path (28), wherein the second bias supply (50) is connected to the second signal path (30), and wherein the first bias supply (48) and the second bias supply (50) are independent of each other,
wherein the first bias supply (48) comprises a first half bridge allowing to set a bias voltage for the at least one first diode (32), and wherein the second bias supply (50) comprises a second half bridge allowing to set a bias voltage for the at least one second diode (40).

2. The switching circuit of claim 1, wherein the control circuit (22) further comprises at least one RF suppressing element (34), wherein the at least one RF suppressing element (34) is arranged in the first signal path (28), in the second signal path (30), and/or in series with the first signal path (28) and the second signal path (30).

3. The switching circuit of claim 2, wherein the at least one RF suppressing element (34) is arranged in the first signal path (28), wherein the at least one RF suppressing element (34) is arranged in series with the at least one first diode (32).

4. The switching circuit according to any one of the preceding claims, wherein the first signal path (28) and the second signal path (30) each are to connected to a common connection point (26), and wherein the switchable element (20) is connected to the common connection point (26).

5. The switching circuit according to any one of the preceding claims, wherein the switchable element (20) is a diode.

6. The switching circuit of claim 5, wherein the switchable element (20) is or comprises a PIN diode, a PN-Si diode, or a PN-SiC diode.

7. The switching circuit according to any one of the preceding claims, wherein the at least one first diode (32) is a PIN diode, a PN-Si diode, or a PN-SiC diode, and/or wherein the at least one second diode (40) is a PIN diode, a PN-Si diode, or a PN-SiC diode.

8. The switching circuit according to any one of the preceding claims, wherein the first signal path (28) comprises a plurality of first diodes (32).

9. The switching circuit according to any one of the preceding claims, wherein the second signal path (30) comprises a plurality of second diodes (40).

10. An impedance tuning network, wherein the impedance tuning network (52) comprises at least one switching circuit (10) according to any one of the preceding claims.

11. The impedance tuning network of claim 10, wherein the impedance tuning network (52) comprises at least one impedance tuning module (62), wherein the impedance tuning module (62) comprises at least one reactance and the at least one switching circuit (10), and wherein the at least one switching circuit (10) is configured to selectively connect the at least one reactance to or into a RF signal path (60) of the impedance tuning network (52).

12. The impedance tuning network of claim 10 or 11, wherein the impedance tuning network (52) is established as an impedance matching network, particularly for plasma processes or for an RF antenna (66).

13. The impedance tuning network of claim 10 or 11, wherein the impedance tuning network (52) is configured to tune an impedance characteristic of a tunable filter.
